(19) Europäisches Patentamt
European Patent Office
Office européen des brevets

(11) **EP 2 751 826 B1**

## (12) EUROPÄISCHE PATENTSCHRIFT

(45) Veröffentlichungstag und Bekanntmachung des Hinweises auf die Patenterteilung:
**14.01.2015 Patentblatt 2015/03**

(21) Anmeldenummer: **12778597.0**

(22) Anmeldetag: **25.08.2012**

(51) Int Cl.:
***H01J 25/55*** *(2006.01)*          ***H05H 1/46*** *(2006.01)*

(86) Internationale Anmeldenummer:
**PCT/DE2012/000865**

(87) Internationale Veröffentlichungsnummer:
**WO 2013/029593 (07.03.2013 Gazette 2013/10)**

### (54) VORRICHTUNG ZUR ERZEUGUNG VON THERMODYNAMISCH KALTEM MIKROWELLENPLASMA

APPARATUS FOR GENERATING THERMODYNAMICALLY COLD MICROWAVE PLASMA

DISPOSITIF DE PRODUCTION DE PLASMA MICRO-ONDES THERMODYNAMIQUEMENT FROID

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.08.2011 DE 102011111884**

(43) Veröffentlichungstag der Anmeldung:
**09.07.2014 Patentblatt 2014/28**

(73) Patentinhaber: **WEISGERBER, Martin**
**53179 Bonn (DE)**

(72) Erfinder: **WEISGERBER, Martin**
**53179 Bonn (DE)**

(56) Entgegenhaltungen:
**EP-A1- 0 503 082     EP-A2- 0 420 117**
**US-A- 3 384 783     US-A- 5 159 241**
**US-B1- 7 106 004**

- **SAYAPIN ET AL.: "Transient operation of the relativistic S-band magnetron with radial output", JOURNAL OF APPLIED PHYSICS, Bd. 109, Nr. 6, 15. März 2011 (2011-03-15), Seiten 1-5, XP002691538, USA ISSN: 0021-8979, DOI: 10.1063/1.3553839**

**Beschreibung**

Die Erfindung betrifft eine Vorrichtung, um mittels hochfrequenter Mikrowellen in einem geeigneten Prozessraum unter Standard Atmosphären Bedingungen ein thermodynamisch kaltes Plasma zu erzeugen.

Allgemein werden Plasmen für eine Vielzahl industrieller, medizinischer und anderer Anwendungen in der Oberflächenbehandlung eingesetzt. Nahezu alle Ausführungsformen der Plasmatechnik finden jedoch unter Niederdruck- oder Vakuumbedingungen statt. Es wäre wünschenswert, diese Aufgaben ebenfalls unter Standard Atmosphären Bedingungen durchführen zu können.

Aus der Schrift DE 10 2008 018 827 B4 ist die Erzeugung eines solchen, unter Standard Atmosphären Bedingungen arbeitenden, Plasmas durch eine Bogenentladung bekannt. Plasmaerzeugungssysteme auf dieser technologischen Basis besitzen einige inhärente Nachteile. Die beiden wichtigsten sind zum einen die hohe Temperatur des erzeugten Plasmas, die systembedingt über 120° C (meist weit darüber) beträgt und damit eine Anwendung auf wärmeempfindliche Materialien nicht zulässt. Zum anderen ist es die geringe Standzeit der Elektrode, welche durch die andauernde elektrische Entladung stark beansprucht wird. Zusätzlich benötigen diese Systeme sowohl finanziell als auch technologisch aufwendige elektrische Leistungsstufen, um den Betrieb mit typischen Spannungen von 25 kV und typischen Frequenzen von 35 kHz zu gewährleisten. Darüber hinaus sind diese Systeme nicht in ihrer energetischen Leistung skalierbar.

In der Schrift DE 10 2004 060 068 B4 wird zwar eine unter Standard Atmosphären Bedingungen arbeitende Plasmaquelle für Beschichtungsaufgaben beschrieben, die durch Anwendung von Mikrowellen arbeitet. Bei genauer Textanalyse zeigt sich jedoch, wie auch bei allen anderen Schriften zu Mikrowellenplasmen z.B. US 2003/0203125 A1, EP 1 156 511 A1 oder EP 2 080 424 B1, dass doch nur im Niederdruckbereich bis nahe an den Standard Atmosphären Bedingungen gearbeitet werden kann und es sich nur um eine durch das Plasma verstärkte chemische Gasphasenabscheidung (*Plasma-Enhanced-Chemical-Vapor-Deposition*) oder wie im Falle der EP 0 420 117 A2 um eine Plasma verstärkte physikalische Gasphasenabscheidung (*Plasma-Enhanced-Physical-Vapor-Deposition*) und somit nicht um eine reine Plasmaanwendung handelt.

Die Druckschrift EP 0 674 369 B1 beschreibt einen durch Mikrowellen angetriebenen Gaslaser, bei dem allerdings die Mikrowelle nur als Transportmittel der Energie fungiert und die Anregung des Lasergases durch eine elektrische Entladung an einem bestimmten Reaktionsort erfolgt. Es handelt sich somit um etwas wie eine "elektrodenlose Form einer Bogenentladungstechnik", jedoch nicht um eine unmittelbare Kopplung der Mikrowelle mit dem Prozessgas.

Nach dem selben Prinzip funktioniert eine weitere Erfindung eines Gaslasers, wie in der US 4 004 249 A beschrieben. Auch hier wird eine elektrische Überschlagsentladung für die Anregung eines speziellen Lasergases ($CO_2$ + He + $N_2$) für die Laserfunktion genutzt. Durch eine konzentrische Anordnung mehrerer Mikrowellenleiter mit abschließender elektrischer Überschlagsentladung kann hier eine erhöhte Energiedichte innerhalb des Lasergases und damit eine stärkere Besetzungsinversion erreicht werden.

Die Notwendigkeit einer Niederdruck- bzw. sogar Vakuumumgebung für eine erfolgreiche Übertragung der Mikrowellen (EP 0 359 336 B1) und Anwendung eines mikrowellenerzeugten Plasmas folgt aus der zu geringen Energiedichte der zur Plasmaerzeugung eingesetzten Mikrowelle, deren Arbeitsfrequenz typischer Weise bei 2,45 GHz liegt; so z.B. beschrieben in den Druckschriften US 4 004 249 A oder EP 0 674 369 B1. Auch die Kopplung mehrerer Mikrowellen durch Überlagerung, wie in der JP 2001 192 840 A beschrieben, reicht nicht alleine für eine Plasmabildung aus, sondern der Einsatz spezieller Niederdruck Prozessgase (z.B. $CO_2$ + He + $N_2$) in einer abgeschlossenen Prozesskammer ist notwendig. US 5 159 241 A offenbart ein relativistisches Magnetron mit einem Feldemissionskathode und einer die Kathode umgebenden Anode, wobei die Anode Resonator-Hohlräumen gegenüber der Kathode aufweist.

Darüber hinaus stellt die Notwendigkeit einer Niederdruck- bzw. sogar Vakuumumgebung erhebliche Belastungen und Behinderungen für den industriellen Einsatz mikrowellenerzeugter Plasmasysteme dar. Denn neben dem nicht-kontinuierlichen Produktionsprozess sind weiterhin umfangreiche Aufwendungen für Niederdruck- bzw. Vakuumsysteme und die Plasmakammern sowie deren regelmäßige Reinigung notwendig. Wollte man den Prozess in einem kontinuierlichen Produktionsprozess integrieren, so wären wirtschaftlich nicht tragbare Aneinanderreihungen von Schleusen und Unterdruckkammern zu installieren.

Darüber hinaus sind die bekannten mikrowellenbasierten Plasmaanlagen unhandlich große und schwergewichtige Systeme, mit den entsprechenden Nachteilen für die industrielle Anwendbarkeit.

Aufgabe der Erfindung ist es ein sowohl in seiner energetischen Leistung als auch Anwendungsfläche skalierbares Plasmaerzeugungssystem darzustellen, welches unter Standard Atmosphären Bedingungen arbeitet und auf Grund der Anregung mittels Mikrowellen einerseits thermodynamisch kalt ist und andererseits keine großen technologischen wie finanziellen Aufwände erzeugt, sowie möglichst kompakt und leichtgewichtig ausgeführt ist.

Erfindungsgemäß wird diese Aufgabe mit einer Vorrichtung, die die Merkmale gemäß Anspruch 1 aufweist, erfüllt.

Vorteilhafte Ausgestaltungsformen und Weiterbildungen können mit den in den untergeordneten Ansprüchen bezeichneten Merkmalen erreicht werden.

Die erfindungsgemäße Ausbildung der mikrowellenangeregten Plasmaquelle ist dergestalt, dass die in mindestens einer separierten Mikrowellenquelle erzeugten Mikrowellen hoher Energiedichte durch Hohlleiter einer gegenüber der Umgebung offenen Plasmakammer zugeführt und dort überlagert werden. Die Plasmakammer hat einen polygonalen Querschnitt, der im Grenzfall $\lim\limits_{n\to\infty}$ eines $n$-gons eine Kreisform hat. Im Falle einer polygonalen Querschnittsfläche treten die Hohlleiter orthogonal zur jeweiligen Seitenfläche, im Falle der Kreisform radial, in den Innenraum der Plasmakammer ein. Durch für Mikrowellen transparente Fenster, z.B. aus Quarzglas, verlassen die Mikrowellen die Hohlleiter und breiten sich in der Plasmakammer aus. Um Rückkopplungen der Mikrowellen innerhalb der Plasmakammer auf die Hohlleiter zu minimieren, sind die Austrittsflächen der Hohlleiter gegenüber der inneren Wand der Plasmakammer zurückgesetzt. Durch eine Öffnung in der Oberseite der Plasmakammer kann ein Materiestrom, vorzugsweise gasförmig, wie Umgebungsluft oder ein gewünschtes Prozessgas in die Plasmakammer eingebracht werden. Dieser Materiestrom durchquert die Plasmakammer und wird durch die Anregung in den Plasmazustand versetzt, bevor er durch eine untere Öffnung die Plasmakammer wieder verlässt und der gewünschten Anwendung zugeführt wird. Diese untere Öffnung ist durch eine auswechselbare, der Anwendung entsprechend geometrisch geformte Struktur, z.B. einer Runddüse, realisiert. Mittels unterschiedlich geformter Düsenformen kann der Plasmastrahl strömungsmechanisch beeinflusst und der speziellen Aufgabe optimal angepasst werden, z.B. in Form unterschiedlicher Strömungsquerschnitte.

Der, vorzugsweise gasförmige, Materiestrom kann Kleinstpartikel anderer Substanzen enthalten, also beispielsweise ein Aerosol sein. Diese im Materiestrom enthaltenen Partikel werden während des Durchgangs durch die Plasmakammer ebenfalls in angeregte Zustände versetzt und nachfolgend für spezielle Beschichtungsaufgaben verwendet. Eine prinzipielle Beschränkung auf bestimmte im Materiestrom enthaltene Materialien ist nicht gegeben; grundsätzlich können alle Stoffe zugeführt werden. Welche Stoffe für Anwendungen sinnvoll benutzt werden können, ist im Einzelfall zu bestimmen. Mögliche Anwendungen sind das Auftragen elektrisch leitender Strukturen aus z.B. Kupfer auf z.B. Kunststoff oder Glas.

Für die Erzeugung eines Plasmas unter Standard Atmosphären Bedingungen ist eine ausreichende Energiedichte notwendig. Erfindungsgemäß wird dies durch die Nutzung von Mikrowellen mit einer Frequenz von mehr als 3 GHz, vorzugsweise 30 GHz, erreicht.

Die optimale industrielle Anwendbarkeit eines Systems wird durch geringes Gewicht und möglichst kleine Baugröße erreicht. Diese wirtschaftlich bedeutsame Anforderung wird erfindungsgemäß durch eine spezielle Ausführung der, die Mikrowellen erzeugenden, Strukturen erfüllt. Das System arbeitet nach dem Prinzip des Magnetron, wobei eine spezielle Formgebung und Anordnung der Resonanzkammern die erfindungsgemäße Funktion erst ermöglicht.

Die nachfolgende Beschreibung benutzt das 3-dimensionale zylindrische Koordinatensystem mit den Elementen: Radiusvektor $r$, Azimuth $\varphi$ und Höhe $z$.

Eine metallische, vorzugsweise aus Kupfer geformte Anode besitzt in ihrem Inneren mehrere, vorzugsweise 20, konzentrisch um die Mittelachse der Anode und über den Azimuth äquidistant verteilte Hohlräume, die als elektromagnetischen Resonanzkammern fungieren. Diese Resonanzkammern sind zylindrisch ausgeformt und ihre jeweilige Symmetrieachse ist im Mittelpunkt der Kammer parallel zum Azimuth ausgerichtet. Der Radius der Resonanzkammern ist gleich oder kleiner als 1 cm, vorzugsweise 3,87 mm. Die Höhe der zylindrischen Kammern ist ebenfalls gleich oder kleiner als 1 cm, vorzugsweise 1,5 mm.

Die beliebig, vorzugsweise zylindrisch geformte Anode besitzt im Mittelpunkt entlang der $z$-Achse einen Hohlraum, der nach oben hin offen ist. Jede Resonanzkammer ist durch einen radial ausgerichteten Hohlleiter mit dem Hohlraum der Anode verbunden.

Aufgrund dieser speziellen Anordnung und geometrischen Form der Resonanzkammer wird die leistungsstarke Erzeugung der Mikrowelle bei geringem Platzbedarf und Gewicht ermöglicht. So hat ein Mikrowellenerzeuger ein Volumen von weniger als 10 cm$^3$ und ein Gewicht von weniger als 100 g (ohne die Elektronenquelle und Führungsmagnete gerechnet).

Weiterhin ist die Mikrowellenanregung durch die konzentrische Anordnung der Resonanzkammern thermodynamisch stabil, d.h. die Längenausdehnung bei Erwärmung des Systems hat keinen Einfluss auf die Phasenlagen der Mikrowellen in den einzelnen Resonanzkammern.

Die Auskopplung der Mikrowelle erfolgt aus mindestens einer oder mehreren, vorzugsweise drei Resonanzkammern, die jeweils eine ungerade Anzahl von Resonanzkammern voneinander entfernt sind, durch radial nach außen gerichtete Hohlleiter.

In Abhängigkeit von der geometrischen Form der Plasmakammer führen die Hohlleiter über unterschiedlich gekrümmte Wege zur Plasmakammer.

Eine weitere spezielle Ausführungsform besitzt mehrere, vorzugsweise vier, Mikrowellengeneratoren, von denen jeweils mehrere, vorzugsweise jeweils 3 Hohlleiter die erzeugten Mikrowellen der Plasmakammer zuführen.

Durch die Kopplung mehrerer Mikrowellenerzeuger, kann die energetische Leistung des Plasmasystems in einfacher Weise den Anwendungsanforderungen folgend gesteigert werden.

Eine weitere spezielle Ausführungsform wird durch eine viereckig geformte Plasmakammer mit an jeder Seite gleichmäßig verteilten Mikrowelleneinkopplungen dargestellt. Durch diese allgemeine Rautenform kann ein von außen nach innen in seiner Intensität veränderliches Plasma für spezielle Anforderungen erzeugt werden. Die Ausbringung des Plasmas an der Unterseite der Plasmakammer kann durch schlitzartige oder runde düsenartigen Strukturen in unterschiedlicher Anordnung erfolgen.

Ein weitere spezielle Ausführungsform wird durch eine rechteckig geformte Plasmakammer mit mindestens an den Längsseiten, im allgemeinen an allen Seiten, gleichmäßig verteilten Mikrowelleneinkopplungen dargestellt. Hierdurch wird eine flächige, gleichmäßige Plasmaintensität erreicht. Die Ausbringung des Plasmas an der Unterseite der Plasmakammer kann durch Schlitz- oder in Reihe angeordnete Runddüsen erfolgen.

Kurzbeschreibung der Zeichnungen:

> **Abbildung (1)** zeigt einen Ausschnitt aus dem Mikrowellenerzeuger.

> **Abbildung (2)** zeigt eine Anordnung eines einzelnen Mikrowellenerzeugers mit der Plasmakammer.

> **Abbildung (3)** zeigt eine Anordnung von 4 Mikrowellenerzeugern mit einer Plasmakammer kreisförmigen Querschnitts, so wie sie für punktuelle Anwendungen ausgeführt wird.

> **Abbildung (4)** zeigt eine Anordnung mehrerer Mikrowellenerzeuger mit einer Plasmakammer rechteckigen Querschnitts, so wie sie für flächige Anwendungen ausgeführt wird.

**Abbildung (1)** zeigt einen Ausschnitt aus dem Mikrowellenerzeuger. Die hier zylindrisch geformte Anode **(1)** enthält entlang ihrer Achsenmitte einen Hohlraum **(2)**, in den die Elektronenquelle (nicht dargestellt) eingesetzt ist. Über- und unterhalb der Anode befinden sich die (nicht dargestellten) Führungsmagnete für die Kreisbewegung der Elektronen. Von dem mittleren Hohlraum führen Hohlleiter **(3)** zu den einzelnen, konzentrisch um die Mittelachse der Anode angeordneten Resonanzkammern **(4)**. Von mindestens einer Resonanzkammer führt dann ein weiterer Hohlleiter **(5)** die Mikrowelle zur Plasmakammer.

**Abbildung (2)** zeigt eine mögliche Ausführungsform der Plasmakammer **(6)** mit nur einer Mikrowellenquelle **(7)**. Die Plasmakammer **(6)** ist hier dreieckig geformt und die Mikrowellen werden über drei Hohlleiter **(5a)**, **(5b)** und **(5c)** auf unterschiedlich gekrümmten Wegen orthogonal zu den drei Seitenflächen der Plasmakammer in die Plasmakammer eingebracht. Die Mikrowelle verlässt durch das für Mikrowellen transparente "Fenster" **(8)** den Hohlleiter und breitet sich im Inneren der Plasmakammer aus. Durch die Öffnung **(9)** kann ein Materiestrom, Prozessgas oder Aerosol in die Plasmakammer eingeführt werden. An der Unterseite der Plasmakammer kann eine den Anforderungen der Anwendung entsprechend ausgeformte düsenartige Struktur montiert werden, um eine optimale Anwendung zu gewährleisten.

**Abbildung (3)** zeigt eine mögliche Ausführungsform der Plasmakammer **(6)** mit 4 Mikrowellenquellen **(7)**. Aus jeder der Mikrowellenquellen leiten 3 Hohlleiter **(5a)**, **(5b)** und **(5c)** jeweils die Mikrowelle in die Plasmakammer. Die Plasmakammer kann wie in **Abbildung (3)** dargestellt einen kreisförmigen Querschnitt haben oder wie in einer hier nicht dargestellten Ausführung einen polygonalen Querschnitt haben. Im Falle einer Anordnung mit 4 Mikrowellenquellen wie in **Abbildung (3)** wäre der polygonale Querschnitt in Form eines Dodekaedon. In einer nicht abgebildeten Ausführung mit 3 Mikrowellenquellen wäre der Querschnitt ein Nonagon, usw. In einer allgemeingültigen Beschreibung eines n-gon gilt für die Zahl $n$ des querschnittbeschreibenden $n$-gons folgender Zusammenhang mit der Anzahl i der Mikrowellenerzeuger und der Anzahl $j$ der auskoppelnden Hohlleiter je Mikrowellenerzeuger:

$$n = i \cdot j$$

In **Abbildung (3)** kann ebenfalls durch die Öffnung **(9)** ein Materiestrom in die Plasmakammer eingebracht werden. Durch die montierbare düsenartige Struktur **(10)** wird der angeregte Materiestrom dann optimal der Anwendung zugeführt.

**Abbildung (4)** zeigt eine mögliche Ausführung einer rechteckigen Plasmakammer, bei der zwei Seiten länger als die anderen beiden Seiten sind. Anlagen dieser Form sind zum Beispiel für den flächigen Einsatz bei Bahnwaren vorgesehen.

Entlang beider Längsseiten, im allgemeinen Fall auch entlang der beiden Stirnseiten, sind in gleichmäßigem Abstand die Mikrowellenquellen **(7)** angeordnet. Über die Hohlleiter **(5a)**, **(5b)** und **(5c)** wird die Mikrowellen der rechteckig ausgeformten Plasmakammer **(6)** zugeführt. Die sich gegenüberliegenden Mikrowelleneinspeisungen, in Form mikrowellentransparenter "Fenster" **(8)**, z. B. aus Quarzglas bestehend, können sowohl zueinander versetzt als auch zueinander ausgerichtet angeordnet sein. Durch eine Öffnung **(9)** kann auch in dieser Ausführungsform ein Materiestrom zugeführt werden.

An der Unterseite der rechteckigen Plasmakammer kann eine, auf die Anwendung abgestimmte Düsenform (Schlitzdüse oder Reihung von Runddüsen) montiert werden.

**Patentansprüche**

1. Vorrichtung zur Erzeugung eines Plasmas mittels Mikrowellen, welche durch mehrere, konzentrisch um die Mittelachse einer Anode, welche der z-Achse eines polaren Koordinatensystems entspricht, angeordnete Resonanzkammern **(4)** erzeugt werden und über mindestens einen oder mehrere Hohlleiter **(5)** aus der Resonanzkammer **(4)** herausgeführt werden, wobei die Auskopplung der Mikrowellen aus mindestens einer oder mehreren Resonanzkammern **(4)** erfolgt, die jeweils eine ungerade Anzahl von Resonanzkammern voneinander entfernt sind, wobei die Resonanzkammern **(4)** in einem evakuierten, elektrisch leitfähigen Anodenblock **(1)** verteilt sind,
**dadurch gekennzeichnet,**
**dass**

i die Resonanzkammern (4) zylindrisch ausgeformt sind und
ii ihre Symmetrieachsen parallel zur Winkelkoordinate des polaren Koordinatensystems ausgerichtet sind,
iii wobei jede Resonanzkammer **(4)** durch rechteckige Hohlleiter **(3)** mit dem inneren, entlang der Mittelachse geführten Hohlraum **(2)** der Anode verbunden sind und
iv die nach außen geführten Mikrowellen in einer separierten Plasmakammer **(6)** zur Interferenz gebracht werden und
v dort durch die Mikrowellen unter Standard Atmosphären Bedingungen ein Plasma erzeugt wird.

2. Vorrichtung nach Anspruch 1,
**dadurch gekennzeichnet,**
**dass**

i die zylindrischen Resonanzkammern **(4)** einen Radius von weniger als 1 cm und
ii eine Höhe von weniger als 1 cm haben und
iii eine Mikrowelle einer Frequenz von über 3 GHz im Resonanzfall erzeugt wird.

3. Vorrichtung nach Anspruch 1,
**dadurch gekennzeichnet,**
**dass**

i mehrere, mindestens zwei mikrowellenerzeugende Vorrichtungen **(7)** nach Anspruch 1
ii derart um eine Plasmakammer **(6)** polygonaler, im Grenzfall $\lim_{n \to \infty}$ eines *n*-gons kreisförmiger, Querschnittsfläche angeordnet sind,
iii **dass** die mittels der Hohlleiter **(5)** in die Plasmakammer **(6)** eingebrachten Mikrowellen miteinander interferieren,
iv wobei von einer Seite, der Oberseite, **(9)** ein Materiestrom in die Plasmakammer **(6)** eingebracht wird und
v durch die gegenüberliegende Seite, die Unterseite, wieder ausströmt.

4. Vorrichtung nach Anspruch 3,
**dadurch gekennzeichnet,**
**dass**

i die Innenflächen der Plasmakammer **(6)** ganz oder teilweise mikrowellenreflektierend oder
ii ganz oder teilweise mikrowellenabsorbierend ausgekleidet sind.

5. Vorrichtung nach Anspruch 3,
**dadurch gekennzeichnet,**
**dass**

i die Unterseite durch eine auswechselbare Düse **(10)** ausgeformt ist, deren jeweilige geometrische Ausformung unterschiedliche Strömungsprofile erzeugt.

6. Vorrichtung nach Anspruch 3,
**dadurch gekennzeichnet,**
**dass**

i das Polygon ein Viereck bildet,
ii an dessen Seiten jeweils mindestens eine oder mehrere mikrowellenerzeugende Vorrichtungen **(7)** nach Anspruch 1 dergestalt angeordnet sind,
iii **dass** die über die Hohlleiter **(5)** eingebrachten Mikrowellen gleichmäßig entlang der Seiten verteilt in den Innenraum eindringen und
iv darin miteinander interferieren.

7. Vorrichtung nach Anspruch 6,
**dadurch gekennzeichnet,**
**dass**

i die Unterseite durch eine auswechselbare Düse **(10)** in Form einer Schlitzdüse ausgeformt ist.

8. Vorrichtung nach Anspruch 7,
**dadurch gekennzeichnet,**
**dass**

i statt einer Schlitzdüse eine reihenförmige Anordnung von Runddüsen ausgebildet ist.

9. Vorrichtung nach Anspruch 3,
**dadurch gekennzeichnet,**
**dass**

i innerhalb der polygonalen Plasmakammer **(6)** strömungsführende Teile
ii aus mikrowellenreflektierendem Material derart angebracht sind,
iii **dass** sie zum einen den Materiestrom führen und
iv zum anderen gleichzeitig die eingebrachten Mikrowellen auf den geführten Materiestrom fokussieren.

**Claims**

1. Apparatus for generating a plasma by microwaves, which are generated by multiple resonant cavities **(4)**, arranged concentrically around the centre axis of an evacuated, electricity conducting anode block **(1)**, which axis corresponds to the z-axis of a cylindrical coordinate system, and said microwaves coupled out of one or more resonant cavities **(4)**, separated by an uneven number of resonant cavities **(4)**, via at least one or more hollow wave guides **(5)** comprising:

   i) said resonant cavities **(4)** are of cylindrical form and
   ii) said resonant cavities **(4)** have their axis of symmetry oriented parallel to the azimuthal coordinate of the cylindrical coordinate system, where any one of
   iii) said resonant cavities **(4)** is connected to the excavation **(2)** along the centre axis of said anode block **(1)** via rectangular hollow conductors **(3)** and
   iv) said coupled out microwaves are injected into a separated plasma chamber **(6)** and generate a plasma under standard atmospheric conditions by subsequent superposition of waves with constructive interference.

2. An apparatus in accordance with claim **1** comprising:

   i) said cylindrical shaped resonant cavities **(4)** having a radius of less than **1** cm and
   ii) said cylindrical shaped resonant cavities having a height of less than 1 cm and
   iii) said cylindrical shaped resonant cavities generating a microwave with frequency of more than 3 GHz when in resonance.

3. An apparatus in accordance with claim **1** comprising:

   i) multiple, at least two, of said microwave generating apparatus **(7)**
   ii) being arranged around a plasma chamber **(6)** with polygonal, in the limiting case $\lim_{n \to \infty}$ of a $n$-gon circular, cross-section
   in such a way that
   iii) said microwaves, fed into the plasma chamber **(6)** via hollow wave guides **(5)**, superpose with constructive interference
   iv) where a material stream is fed through an inlet **(9)** into said plasma chamber **(6)** and
   v) the material stream is be discharged through an outlet on the opposite side.

4. An apparatus in accordance with claim **3** comprising:

   i) said plasma chamber **(6)** is coated with a partial or full microwave reflective material or
   ii) said plasma chamber **(6)** is coated with a partial of full microwave absorbing material.

5. An apparatus in accordance with claim **3** comprising:

   i) an outlet **(10)** of said plasma chamber **(6)** being formed by a changeable nozzle, whose particular geometric shape generates different flow profiles.

6. An apparatus in accordance With claim **3** comprising:

   i) said polygonal cross-section of the plasma chamber **(6)** forms a quadrangle,
   ii) at whose sides at least one or more microwave generating apparatus **(7)** in accordance with claim **1** are attached respectively
   so that
   iii) said microwaves are fed, uniformly arranged along each side, into said plasma chamber via hollow wave guides **(5)**
   and
   iv) said microwaves subsequently interfere with each other.

7. An apparatus in accordance with claim **6** comprising:

   i) said changeable nozzle **(10)** is formed as slot-nozzle.

8. An apparatus in accordance with claim **7** comprising:

   i) said changeable nozzle **(10)** is formed as linear sequence of round nozzles instead of a slot nozzle.

9. An apparatus in accordance with claim **3** comprising:

   i) said plasma chamber **(6)** with polygonal cross-section contains stream forming parts
   ii) made of microwave reflective material in such a way, that said stream forming parts
   iii) on the one hand guide the material stream through said plasma chamber
   and
   iv) on the other hand focus said microwave onto the material stream.

**Revendications**

1. Dispositif de production d'un plasma à l'aide de micro-ondes
   qui sont générées,
   par plusieurs chambres de résonance (4) disposées de façon homocentrique autour de l'axe moyen d'une anode qui correspond
   à l'axe z d'un système de coordonnées polaires,
   et qui sont conduites hors de la chambre de résonance (4) via au moins un ou plusieurs guide(s) d'ondes (5),
   processus au cours duquel le découplage des micro-ondes se fait à partir d'au moins une ou plusieurs chambre(s) de résonance,
   qui sont tous séparées entre elles par un nombre impair de chambres de résonance,
   où les chambres de résonance (4) sont réparties dans un bloc anodique dans lequel le vide a été fait et à conductibilité électrique,
   **caractérisé en ce que**,

   i) les chambres de résonance soient cylindriques et que
   ii) leurs axes de symétrie soient parallèles aux coordonnées angulaires du système de coordonnées polaires,
   iii) où chaque chambre de résonance (4) est reliée via des guides d'ondes rectangulaires à la cavité intérieure (2) de l'anode le long de l'axe moyen, et
   iv) que les micro-ondes sorties soient amenées en interférence dans une chambre à plasma (6) séparée et qu'un plasma y soit produit grâce aux micro-ondes dans des conditions atmosphériques standards.

2. Dispositif selon la revendication 1,
   **caractérisé en ce que**,

   i) les chambres de résonance cylindriques (4) possèdent un rayon inférieur à 1 cm et
   ii) une hauteur inférieure à 1 cm et
   iii) qu'un rayonnement de micro-ondes d'une fréquence de plus de 3 GHz soit créé dans le cas de résonance.

3. Dispositif selon la revendication 1,
   **caractérisé en ce que**,

   i) plusieurs, au minimum deux dispositifs générant des micro-ondes (7) soient disposés, selon la revendication 1,
   ii) autour d'une chambre à plasma (6) polygonale, dans le cas limite lim d'une section transversale circulaire n-gone de sorte
   iii) que les micro-ondes introduites dans la chambre à plasma (6) via le guide d'ondes (5) interfèrent entre elles,
   iv) permettant à un courant de matière d'être introduit sur un côté, le côté supérieur, (9) dans la chambre à plasma (6) et
   v) de ressortir par le côté opposé, le côté inférieur.

4. Dispositif selon la revendication 3,
   **caractérisé en ce que**,

   i) la surface interne de la chambre à plasma (6) soit revêtue, totalement ou partiellement de façon à réfléchir les micro-ondes
   ii) ou totalement ou partiellement de façon à absorber les micro-ondes.

5. Dispositif selon la revendication 3,
   **caractérisé en ce que**,

   i) le côté inférieur soit façonné par une buse (10) interchangeable, dont chaque façonnage géométrique crée différents profils de l'écoulement.

6. Dispositif selon la revendication 3,
   **caractérisé en ce que**,

   i) le polygone forme un quadrilatère,
   ii) sur chaque côté duquel un ou plusieurs dispositif(s) générant des micro-ondes (7) est/sont disposé(s), selon la revendication 1, de telle sorte que
   iii) les ondes introduites par le guide d'ondes (5) pénètrent à l'intérieur en se répartissant uniformément le long des côtés et
   iv) y interfèrent entre elles.

7. Dispositif selon la revendication 6,
   **caractérisé en ce que**,

   i) La face inférieure soit façonnée par une buse (10) interchangeable sous la forme de buse à fente.

8. Dispositif selon la revendication 7,
   **caractérisé en ce que**,

   i) un alignement de buses rondes soit formé à la place d'une buse à fente

9. Dispositif selon la revendication 3,
   **caractérisé en ce que**,

   i) à l'intérieur de la chambre à plasma (6) polygonale, des pièces guidant l'écoulement soient
   ii) introduites à partir du matériau réfléchissant les micro-ondes de sorte
   iii) qu'elles accèdent à l'un des courants de matière et

iv) que les micro-ondes introduites se focalisent en même temps sur le courant de matière traversé.

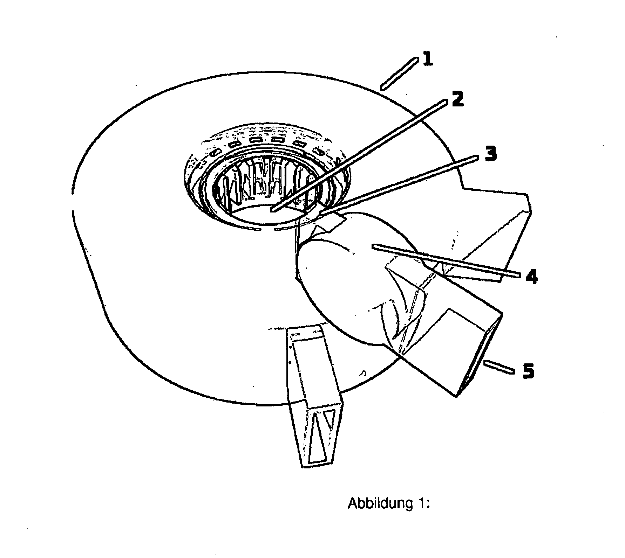

Abbildung 1:

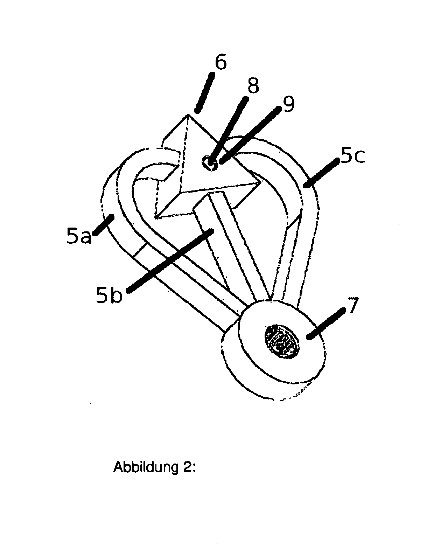

Abbildung 2:

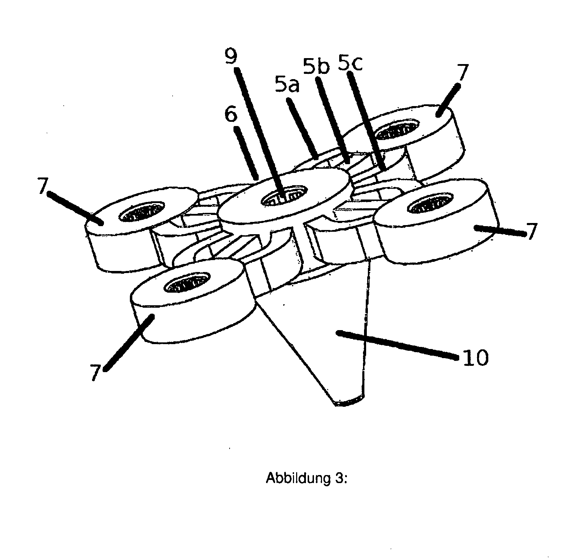

Abbildung 3:

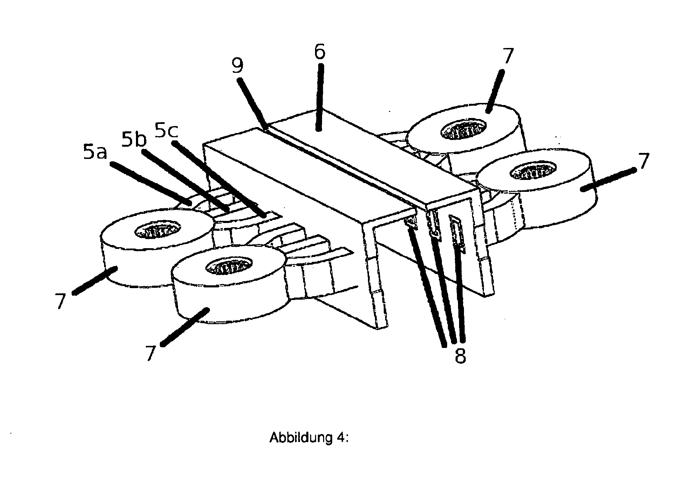

Abbildung 4:

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008018827 B4
- DE 102004060068 B4
- US 20030203125 A1
- EP 1156511 A1
- EP 2080424 B1
- EP 0420117 A2

- EP 0674369 B1
- US 4004249 A
- EP 0359336 B1
- JP 2001192840 A
- US 5159241 A